# EUROPEAN PATENT APPLICATION

(11) **EP 1 403 712 A2**
(43) Date of publication of application: **31.03.2004**
(21) Application number: 03255923.9
(22) Date of filing: 22.09.2003
(51) Int. Cl.: G03F 7/20

(54) **Lithographic apparatus and device manufacturing method**

(30) Priority: 24.09.2002 EP 02256615
(71) Applicant: ASML Netherlands B.V., 5503 LA Veldhoven (NL)
(72) Inventor: van de Nieuwelaar, Norbertus Josephus Martinus, 5043 AP Tilburg (NL)
(74) Representative: Leeming, John Gerard

(57) **Abstract**

A lithographic projection apparatus 1 and a method in which an interferometer system 6, 8, 14, 15, 16 has a reach extending over a first measurement station 4 and a second exposure station 2. The apparatus stores the position of the mask MA relative to the mask table MT initially. A wafer table WTa may be transferred by a planar motor from the first to the second station while fully under the control of the interferometer system. The critical path through the exposure stage 2 may then be reduced. The apparatus stores the position of the wafer W relative to the wafer table WTa during the measurement stage. Subsequent alignment in the exposure stage may then be performed in a shorter time if the position of a mask relative to a mask table is known.

## Description

The present invention relates to a lithographic projection apparatus comprising:
- at least one substrate table for holding a substrate;
- a first station at which, for example, measurement of the substrate may be made;
- a second station at the substrate is exposed;
- a displacement measuring system for measuring displacements of said substrate table in said first and second stations;
- transfer means for transferring said substrate table between said first and said second stations;
- a radiation system, associated with said second station, for providing a projection beam of radiation;
- a support structure for supporting patterning means, the patterning means serving to pattern the projection beam according to a desired pattern;
- a projection system for projecting the patterning beam onto a target portion of the substrate, when said substrate is at said second station; wherein
- said displacement measuring system is adapted to continuously measure displacements of said substrate table in at least two directions during transfer between said first and second stations.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.

A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In a present dual-stage apparatus there are two stations. A substrate to be processed is first loaded onto a substrate table. This table is then moved into the first station. In the first station measurements of the physical characteristics of the substrate are taken and stored. When the measurements are complete, the substrate table is transferred into the second station. This step of transferring involves releasing the substrate table from a positioning means of the first station and clamping the substrate table to a positioning means of the second station. In the second station the substrate table is coarsely aligned, to within about 10 µm, with a mask. The mask is then finally aligned before the process of exposure can begin. When exposure is complete, the substrate table is released from the movement apparatus of the second station and the exposed substrate removed. This apparatus allows throughput of the substrate to be increased because while exposure of one substrate is occurring, the next substrate to be processed may be in the measurement station. Thus, after the first wafer has been processed, the exposure station may be re-used as soon as it has finished processing a substrate.

Another dual stage device is described in US 5,715,064. In this device the position of a substrate table is continuously monitored throughout its movement from a first station to a second station. The two substrate tables in the first and second stations are limited to moving in lock step. Only five relative movements of the tables are possible. This limits the throughput and also the scanning paths possible during exposure.

The limiting factor to the throughput is the critical path. A dual wafer stage wafer scanner is designed to optimally use the projection system. Therefore, the expose cycle (the exposure process) forms the critical path. The critical path consists of steps of transferring the substrate table from the measurement station into the exposure station, coarsely aligning the substrate table with the mask, followed by fine alignment and a final step of actually exposing the substrate. If we assume that the exposure process itself is unchanged, then throughput of the apparatus may be improved by reducing the time spent on other steps in the critical path.

It is an object of the present invention to improve the throughput of a multiple stage lithographic apparatus.

This and other objects are achieved according to the invention in lithographic apparatus as specified in the opening paragraph, characterized in that: said transfer means is a planar motor.

The throughput of the apparatus may therefore be increased because the position of the substrate table is known at all times during its transfer between the first and second station. This means that when the substrate table arrives in the second station there is no need for zeroing, as the position is already known to a high degree of accuracy.

The throughput is further increased by the use of a planar motor. This allows the substrate table to be transferred directly from the measurement station into the exposure station with no delay associated with releasing the substrate table from the movement apparatus of the measurement station and clamping the substrate table to the movement apparatus of the exposure station. Thus, only a safety distance between substrate tables need be provided, and the critical path is further reduced in duration. A further benefit of using a planar motor is that it is possible to transfer the substrate table with no abrupt movements, enabling a smooth lendover between the displacement measuring devices. Additionally there is no limitation to move the substrate table in the lockstep with another table in a different station.

Preferably, the apparatus may additionally comprise: -
- a first measurement system in said first station for measuring a first relative position of said substrate to said substrate table;
- a second measurement system in said second station for measuring a second relative position of said patterning means relative to its supporting structure;
- storage means for storing said first and second relative positions; and
- calculating means for calculating an exposure position based on said first and second relative positions.

By storing the two relative positions an exposure position can be calculated easily. The table can then be moved directly to the exposure position when it is transferred from the first station to the second station.

Preferably, the displacement measurement systems use interferometers. These allow accurate tracking of the relative displacement of the substrate table to within the tolerances required for lithography.

According to a second aspect of the present invention, there is provided a device manufacturing method comprising the steps of:
- providing a substrate that is at least partially covered by a layer of radiation-sensitive material;
- locating said substrate on a substrate table in a first station, said first station being a station in which, for example, measurement of the substrate may be made;
- transferring said substrate table to a second station, said second station being a station in which the substrate is exposed;
- measuring displacements of the substrate table in said first and second stations;
- providing a projection beam of radiation using a radiation system;
- using patterning means to endow the projection beam with a pattern in its cross-section;
- projecting the patterned beam of radiation onto a target portion of the layer of radiation-sensitive material while said substrate is in an exposure position in said second station; and
- continuously measuring displacements of said substrate table during said step of transferring.
characterized by a step of:
- measuring and storing a first relative position of said substrate to said substrate table, while said substrate table is in said first station;
and wherein for the first substrate there is the further step of:
- measuring and storing a second relative position of said patterning means relative to its supporting structure;
and wherein for each subsequent substrate there are the further steps of:
- calculating an exposure position using said stored first and second relative locations; and
- using said exposure position as a destination during said step of transferring.

Thus, the above advantage of eliminating a zeroing step from the critical path may be achieved.

For the first substrate to be processed, the relative position of the patterning means relative to its supporting structure is stored. When several substrates in a batch are processed, each substrate will use the same mask. Therefore, the mask is not changed as each substrate enters and leaves the exposure station. So, by measuring and storing the relative position of patterning means relative to its supporting means for the first wafer, this information can then be combined with information on the position of each subsequent substrate on the substrate table to allow the substrate table to be moved into an exposure position. Some alignment may still be required, but this would only be very small. for example to correct any errors arising due to interferometer system drift or hand-over between interferometers.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention; and
Figure 2 illustrates movements of substrate tables between stations in the lithographic projection apparatus of Figure 1.

In the Figures, corresponding reference symbols indicate corresponding parts.

### Embodiment 1

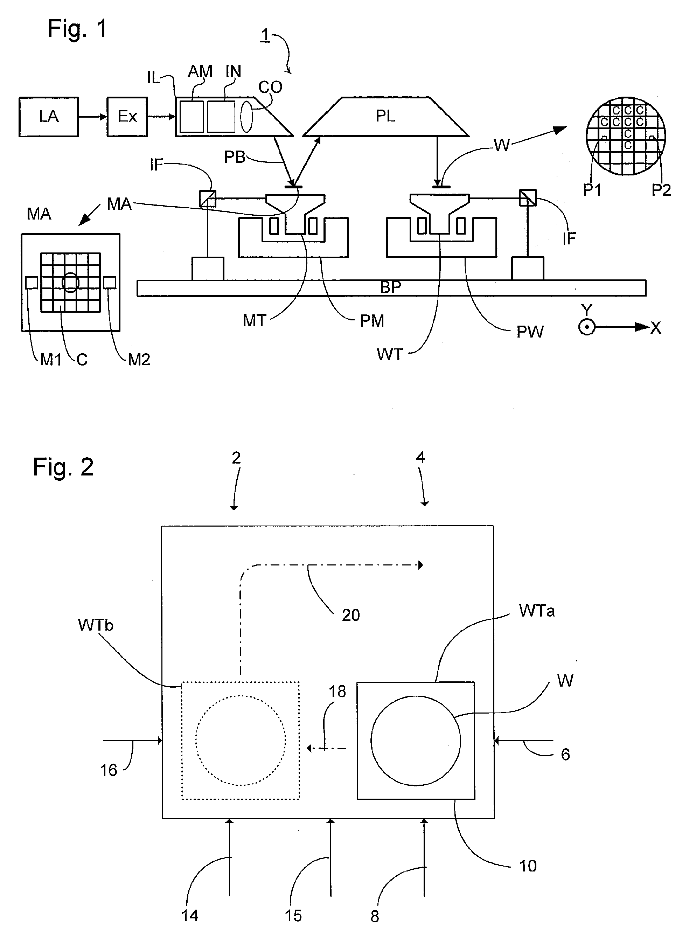

Figure 1 schematically depicts a lithographic projection apparatus according to a particular embodiment of the invention. The apparatus comprises:
. a radiation system Ex, IL, for supplying a projection beam PB of radiation (*e.g.* EUV radiation), which in this particular case also comprises a radiation source LA:
. a first object table (mask table) MT provided with a mask holder for holding a mask MA (*e.g.* a reticle), and connected to first positioning means for accurately positioning the mask with respect to item PL;
. a second object table (substrate table) WT provided with a substrate holder for holding a substrate W (*e.g.* a resist-coated silicon wafer), and connected to second positioning means for accurately positioning the substrate with respect to item PL;
. a projection system ("lens") PL (*e.g.* mirror group) for imaging an irradiated portion of the mask MA onto a target portion C (*e.g.* comprising one or more dies) of the substrate W.

As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (e.g. a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF) the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

Figure 1 illustrates only the exposure station of the lithographic apparatus of the invention - Figure 2 shows both a first measurement station 4 and a second exposure station 2. In the measurement station 4, the characteristics of the substrate W and its relative position on the substrate table WTa are recorded. In the exposure station 2, the substrate W is exposed taking account of the physical characteristics of the wafer measured in the measurement station 4.

In the present embodiment an XY table 10 extends under both the measurement station 4 and the exposure station 2. The wafer table WT is provided with that magnet array (stator) of a planar motor whilst the coil units (armature) are built into the substrate table WT so that the substrate table WT can be moved to any position on the XY table 10. The apparatus is also provided with an alignment system (not illustrated) for aligning the substrate table with the patterning means in the exposure station. The relative displacement of the substrate table WTa is measured by an interferometer system 6, 8, 14, 15, 16. The interferometer system can measure only relative displacements, so the absolute position of substrate and the substrate table WTa is first established by an alignment system associated with the measurement station 4.

To process a substrate W, the substrate W is first clamped onto a substrate table WTa. This substrate table WTa is then moved into the measurement station 4 and its absolute position established. The substrate table, and the substrate W upon it, are then scanned in the measurement station to measure the physical characteristics of the substrate W and its relative position to the substrate table WTa. These measurements are stored for later use in the exposure station 2.

When the measuring process is complete the substrate table WTa is transferred to the exposure station 2 under the control of the planar motor. This path is illustrated by arrow 18 in Figure 2. As the substrate table moves towards the exposure station, it enters the measurement range of interferometer 15. For a short period the displacement of the substrate table WT may be determined by both interferometers 8 and 15. This allows a seamless transfer of the measurement of displacement from interferometer 8 to interferometer 15. Further in the course of the movement of the substrate table WTa it enters the range of measurement of interferometer 14. Thus, its displacement is transferred seamlessly from interferometer 15 to 14.

The apparatus has two substrate tables WTa, WTb so that one can be used for an exposure whilst measurements are performed on the substrate held by the other. It is required that at no point in the process do the substrate tables collide. This will cause significant damage to the apparatus. To avoid collisions, the substrate tables WTa, WTb follow a clockwise path around the XY table 10. This is illustrated by line 20 in Figure 2. Thus, as the substrate table WTa moves into the exposure station 2 there will be a point when the previous substrate table WTb has left the measurement range of the interferometer 16. At this point the displacement of substrate table WTa is measured by both interferometers 6 and 16. Thus, a seamless hand-over between these two interferometers may be achieved.

It will be appreciated that when substrate table WTb leaves the XY table 10 along path 20 it will no longer be possible to measure its displacements with the interferometer system. However, this is not a problem as sufficient accuracy may be achieved using, for example, dead reckoning.

When the substrate table WTa arrives in the exposure station 2, its accurate position is known because its displacement has been continuously tracked by the interferometers 6, 8, 14, 15 and 16 as described above. Thus, there is no need for an initial zeroing step.

Furthermore, in this embodiment a further reduction in the duration of the critical path is achieved by recording the alignment of the patterning means relative to its support structure. All substrates in a batch will use the same mask, which will remain in the mask table MT throughout. Therefore, its position need only be measured for the first substrate in a batch. For all subsequent substrates, because the mask has not been changed, these measurements will still be valid. The data may be combined with the position of the substrate W on the substrate table WT, which has been measured in the measurement station 4, to calculate the required destination of the substrate table WT so that it is positioned ready for exposure. Some alignment will still be required, however, for example because of inaccuracies due to interferometer system drift. There may also be small errors during hand-over between interferometers. However, these errors will only be very small and thus the time for alignment of the mask is significantly reduced resulting in a corresponding reduction in the duration of the critical path.

After the substrate has been processed by the exposure station 2, it leaves the apparatus via a clockwise path 20 as described above.

It will be appreciated that the design of the interferometer system in this embodiment allows the displacement of the substrate tables WTa, WTb to be continuously tracked when it is transferred into the exposure station from the measurement station. Furthermore, the interferometer system is also capable of tracking the displacements of two substrate tables when one is located in the measurement station and another in the exposure station. The displacement of the table in the measurement station is measured by interferometers 6 and 8. The displacement of table in the exposure station 2 is measured by interferometers 14 and 16. Thus, accurate measurements of the displacement of the substrate table WT is achieved at all points during its processing where high accuracy is required, and furthermore the full benefits of parallel processing of the dual-stage device are realized.

The above described embodiment therefore allows the time a substrate spends in the exposure station, which forms the critical path through the apparatus, to be significantly reduced. Previously, the time to swap a chuck when transferring the substrate from the measurement stage to the exposure stage would be approximately 4.7 seconds. Coarsely aligning the substrate table in the exposure stage would then take a further 0.3 seconds, followed by 2 seconds for fine alignment of the mask with the exposure position. Finally there is a 29 second exposure cycle. Therefore, the exposure time accounts for approximately 80% of the critical path through the prior art apparatus.

The critical path takes 36 seconds which allows 100 wafers to be processed per hour when operating in a steady state.

The present embodiment allows a significant reduction in non exposure time during the exposure cycle. The time taken for release and clamping of the table when it is transferred is eliminated by the planar motor. However there is still a short period of time associated with moving the table from the measurement station into the exposure station, and allowing a suitable safety distance from the table ahead of it. A typical value would be approximately 0.7 seconds. It has been noted above that storing the position of both the substrate W relative to the substrate table WT and the mask relative to the mask table allows the zeroing to be eliminated when the table is transferred to the exposure station under continuous interferometer control. Furthermore, the accuracy of the movement is such that the fine mask alignment need only take approximately 0.9 seconds. This is because the errors to be corrected are relatively small. The exposure time is unchanged at 29 seconds. Therefore the exposure time now accounts for approximately 95% of the critical path through the exposure stage. Total time for the critical path is 30.6 seconds which allows 118 wafers per hour to be processed in the steady state.

Examining the time of the critical path alone shows the benefits gained to the throughput in the present invention. However, it is instructive to consider the acceptance test performance (ATP) methodology to examine the performance of the apparatus. The ATP methodology considers the throughput when only one mask is needed for a wafer. A 15 wafer lot is processed and the average time for the 3^{rd} to the 12^{th} wafers is calculated to ensure that the steady state situation is measured. Therefore, the critical path is the same as calculated above, giving a throughput increase of 18 wafers per hour or 18%.

Whilst specific embodiments of the invention have been described above, it will be appreciated that the invention may be practiced otherwise than as described. The description is not intended to limit the invention.

## Claims

1. A lithographic projection apparatus comprising:
- at least one substrate table for holding a substrate;
- a first station at which, for example, measurement of the substrate may be made;
- a second station at the substrate is exposed;
- a displacement measuring system for measuring displacements of said substrate table in said first and second stations;
- transfer means for transferring said substrate table between said first and said second stations;
- a radiation system, associated with said second station, for providing a projection beam of radiation;
- a support structure for supporting patterning means, the patterning means serving to pattern the projection beam according to a desired pattern;
- a projection system for projecting the patterning beam onto a target portion of the substrate, when said substrate is at said second station; wherein
- said displacement measuring system is adapted to continuously measure displacements of said substrate table in at least two directions during transfer between said first and second stations.
**characterized in that** said transfer means is a planar motor.

2. A lithographic projection apparatus according to claim 1 further comprising:
- a first measurement system in said first station for measuring a first relative position of said substrate to said substrate table;
- a second measurement system in said second station for measuring a second relative position of said patterning means relative to its supporting structure;
- storage means for storing said first and second relative positions; and
- calculating means for calculating an exposure position based on said first and second relative positions.

3. A lithographic projection apparatus according to claim 2, wherein said first and/or second measuring system is also an alignment system for aligning said substrate in said first and/or second stations.

4. A lithographic projection apparatus according any preceding claim, wherein said displacement measurement systems comprise interferometers.

5. A device manufacturing method comprising the steps of:
- providing a substrate that is at least partially covered by a layer of radiation-sensitive material;
- locating said substrate on a substrate table in a first station, said first station being a station in which, for example, measurement of the substrate may be made;
- transferring said substrate table to a second station, said second station being a station in which the substrate is exposed;
- measuring displacements of the substrate table in said first and second stations;
- providing a projection beam of radiation using a radiation system;
- using patterning means to endow the projection beam with a pattern in its cross-section;
- projecting the patterned beam of radiation onto a target portion of the layer of radiation-sensitive material while said substrate is in an exposure position in said second station; and
- continuously measuring displacements of said substrate table during said step of transferring.
**characterized by** a step of:
- measuring and storing a first relative position of said substrate to said substrate table, while said substrate table is in said first station;
and wherein for the first substrate there is the further step of:
- measuring and storing a second relative position of said patterning means relative to its supporting structure;
and wherein for each subsequent substrate there are the further steps of:
- calculating an exposure position using said stored first and second relative locations; and
- using said exposure position as a destination during said step of transferring.

6. A computer program comprising a program code means that, when executed on a computer system controlling a lithographic projection apparatus, instructs said lithographic projection apparatus to perform the steps of claim 5.
